Europäisches Patentamt

**European Patent Office**

**Office européen des brevets**

(19)

(11) Numéro de publication: **0 059 138**
**B1**

(12) **FASCICULE DE BREVET EUROPEEN**

(45) Date de publication du fascicule du brevet:
**16.09.87**

(21) Numéro de dépôt: **82400232.3**

(22) Date de dépôt: **09.02.82**

(51) Int. Cl.⁴: **G 01 S 1/30, G 01 R 25/08**

(54) **Procédé de radio-localisation par détermination de phases d'ondes électromagnétiques et dispositif récepteur pour la mise en oeuvre de ce procédé.**

(30) Priorité: **13.02.81 FR 8102906**

(43) Date de publication de la demande:
**01.09.82 Bulletin 82/35**

(45) Mention de la délivrance du brevet:
**16.09.87 Bulletin 87/38**

(84) Etats contractants désignés:
**BE DE GB IT SE**

(56) Documents cités:
**FR - A - 1 010 811**
**US - A - 2 513 316**
**US - A - 3 214 759**
**US - A - 3 689 926**
**US - A - 3 968 493**
**US - A - 3 974 502**

(73) Titulaire: **M.L.R. ELECTRONIQUE, 13, rue François Luneau, F-44330 Vallet (FR)**

(72) Inventeur: **Lamiraux, Christian, 6, rue de l'Allier, F-44230 St. Sebastien sur Loire (FR)**

(74) Mandataire: **Weinstein, Zinovi et al, Cabinet Z. WEINSTEIN 20, Avenue de Friedland, F-75008 Paris (FR)**

ACTORUM AG

## Description

La présente invention concerne un procédé de radio-localisation d'un véhicule selon le préambule de la revendication principale et un dispositif récepteur pour la mise en œuvre de ce procédé.

Un tel procédé et un dispositif pour sa mise en œuvre sont déjà décrits dans le brevet US N° 3 689 926. Ce brevet fait état d'un récepteur qui est équipé, typiquement pour les récepteurs connus, de moyens oscillateurs locaux spécifiques, formant horloge, qui doivent être synchrones ou rendus synchrones par asservissement aux signaux à mesurer. A cette fin, le récepteur connu doit être équipé de circuits d'asservissements particuliers destinés à synchroniser les moyens oscillateurs locaux aux signaux devant être traités. La présence de tels moyens oscillateurs et des circuits d'asservissement confèrent au récepteur connu une structure très complexe.

La présente invention a pour objectif de proposer un procédé et un dispositif beaucoup plus simple et donc d'un moindre coût.

Pour atteindre cet objectif, le procédé et le récepteur proposés par l'invention n'utilisent qu'un seul canal récepteur, qui est commuté successivement, pendant chacun des cycles de commutation successifs, aux trois bandes de fréquence différentes, selon la partie caractérisante des revendications 1 et 4.

L'invention sera mieux comprise et les buts, caractéristiques, détails et avantages de celle-ci apparaîtront plus clairement au cours de la description explicative qui va suivre faite en référence aux dessins schématiques annexés donnés uniquement à titre d'exemple illustrant un mode de réalisation de l'invention et dans lesquels:

La figure 1 est un schéma synoptique du canal de réception du dispositif récepteur selon l'invention.

La figure 2 est un schéma synoptique des canaux de séparation des basses fréquences.

La figure 3 montre une cellule de filtrage des canaux de séparation suivant la figure 2.

La figure 4 est un schéma synoptique du système logique à micro-processeur du récepteur selon la présente invention.

La figure 5 illustre sous forme d'un schéma bloc le système de traitement et d'affichage des signaux de sortie fournis par le système logique du récepteur selon la présente invention; et

La figure 6 illustre la coordination dans le temps des signaux de commande et les instants de mesure, qui détermine le fonctionnement du dispositif récepteur selon la présente invention.

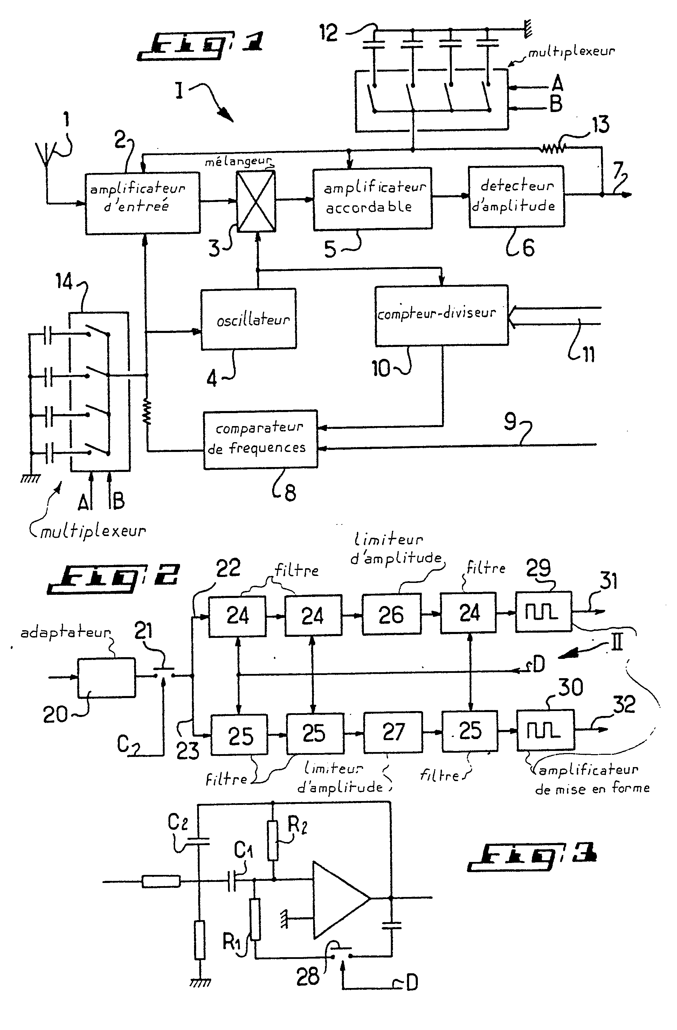

Dans le mode de réalisation de l'invention qui est représenté sur les figures, le dispositif récepteur suivant l'invention comprend un seul canal de réception I des signaux captés par l'antenne 1. La figure 1 montre ce canal de réception. Les signaux proviennent des stations foyers fixes non représentées et comprennent par exemple une bande de fréquences fondamentales contenant deux couples d'ondes de radio-fréquence écartés respectivement par une basse fréquence, une seconde bande de fréquence contenant une bande modulée par les deux signaux de basse fréquence et une bande de fréquence contenant deux couples d'ondes de levée d'ambiguïté chacune en relation arithmétique connue avec la fréquence fondamentale d'un couple d'ondes. Ce canal est conçu pour que sa fréquence d'accord soit cycliquement commutable sur les différentes bandes de fréquences reçues par l'antenne 1, sous la commande d'un dispositif logique pourvu d'un micro-processeur et représenté sur la figure 4. A chaque état de commutation, le canal de réception produit deux basses fréquences superposées qui sont ensuite séparées l'une de l'autre par un étage de filtrage et de sélection II (figure 2). Chaque signal de basse fréquence est ensuite transmis au dispositif logique à micro-processeur III illustré par la figure 4. Ce dispositif corrige les signaux décalés dans le temps et devant être comparés et les envoie au dispositif de traitement et d'affichage représenté de façon détaillée sur la figure 5.

On décrira ci-après de façon détaillée les différents dispositifs constitutifs du récepteur selon l'invention.

Le canal d'entrée I comprend, suivant la figure 1, un amplificateur d'entrée 2 accordable. L'entrée de ce dernier est relié à l'antenne 1 et sa sortie est connectée à l'entrée d'un mélangeur 3 relié par une autre entrée à un oscillateur local 4 dont la fréquence est variable. Le mélangeur 3 est conçu pour produire à sa sortie un signal de fréquence intermédiaire de valeur constante, par exemple de 430 KHz. Ce signal de sortie correspond à la différence des signaux qui lui sont appliqués. La sortie du mélangeur 3 est reliée à l'amplificateur accordable 5 destiné à porter les signaux reçus du mélangeur 3 à un niveau de l'ordre du volt. La sortie de l'amplificateur 5 est reliée à un détecteur d'amplitude 6. Ce dernier fournit les signaux à basse fréquence dont on veut mesurer les phases et une composante de tension continue, représentative de l'amplitude du champ électrique reçue sur la fréquence radio. La composante moyenne est isolée par filtre passe-bas à élément RC. De la sortie du détecteur 6, les signaux de basse fréquence sont transmis par le conducteur 7 à l'étage séparateur représenté sur la figure 2.

La fréquence d'accord de l'amplificateur d'entrée 2 et de l'oscillateur 4 sont déterminés à l'aide de diodes à capacité variable par une tension de commande produite par un comparateur de fréquence 8 qui reçoit à une entrée, par l'intermédiaire d'un conducteur 9, un signal de référence produit par le dispositif logique à micro-processeur (figure 4) et à une autre entrée le signal de sortie d'un compteur-diviseur de fréquences 10 relié à la sortie de l'oscillateur local 4. Le taux de division du compteur-diviseur 10 est commandé par un «bus» de commande à neuf conducteurs 11 provenant également du dispositif logique (figure 4). La fréquence de l'oscillateur 4 est définie numériquement par le choix du taux de division du compteur 10. Le circuit d'accord de l'oscillateur 4 est compensé par un condensateur d'appoint afin de maintenir un écart constant égal à 430 KHz entre la fréquence de réception et sa fréquence locale sur la gamme s'étendant de 1,6 à 2,6 MHz.

Les gains des amplificateurs 2 et 5 sont réglables par application rétro-active de la tension à la sortie du démodulateur 6, à travers une résistance 13, à ces amplificateurs. Un multiplexeur 12 est prévu qui établit le branchement d'un condensateur pour chacune des fréquences radio à amplifier, sous l'action de signaux logiques A et B provenant du dispositif logique à micro-processeur. Le canal de réception comprend en outre un multiplexeur 14 qui relie un de plusieurs condensateurs aux entrées de commande de l'amplificateur d'entrée 2 et de l'oscillateur local 4, également sous la commande des signaux logiques A et B. Les multiplexeurs 12 et 14 permettent de minimiser le temps d'établissement des signaux détectés en mémorisant pour chaque fréquence radio les tensions pseudo-continues d'asservissements qui règlent la fréquence d'accord et le gain sur cette fréquence.

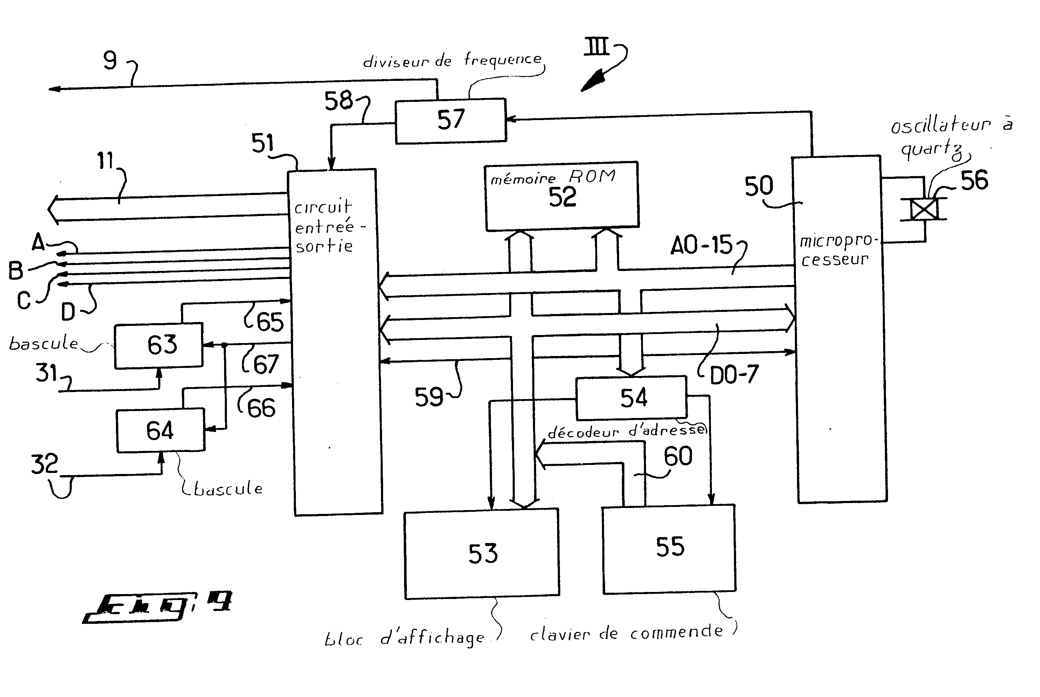

La figure 2 montre l'agencement de l'étage séparateur II des basses fréquences détectées par le détecteur d'amplitude 6 et reçues par le conducteur 7. Cet étage séparateur comprend un adaptateur 20 accomplissant le rôle de séparateur. Il est adapté pour régler le niveau d'excitation des cellules de filtrage et de réduire les composantes de tension qui suivent les commutations de fréquences d'accord HF. Cette fonction est complétée par un interrupteur de signaux transitoires 21 qui reste ouvert sous l'action d'un signal C pendant une période d'environ 15 msec. Le signal C provient du dispositif logique à micro-processeur suivant la figure 4. L'étage séparateur comprend deux voies de sélection basse fréquence 22, 23 chacune constituée de plusieurs cellules de filtrages 24, 25 montées en série et d'un limiteur d'amplitude 26, 27 inséré, dans l'exemple représenté, entre la deuxième et la troisième cellule de filtrage. Comme il ressort de la figure 3, chaque cellule de filtrage est réalisée sous forme d'un filtre actif de bande dont la fréquence d'accord est définie par les résistances R1, R2 et des condensateurs C1, C2 et dont le coefficient de surtension est fonction croissante du rapport R2/R1, lorsqu'un interrupteur 28 est ouvert. Ce dernier se ferme sous l'action d'un signal d'initialisation D provenant du dispositif logique (figure 4). La fermeture de cet interrupteur 28 abaisse le coefficient du filtre actif à une valeur faible de l'ordre de l'unité, lui faisant reprendre rapidement le potentiel d'initialisation qui correspond à l'application d'un signal d'amplitude nulle. Les signaux filtrés s'établissent ensuite dans les cellules de filtrage 24, 25 de manière à atteindre leur valeur finale à la transition du signal A qui suit. Le signal détecté est alors coupé des filtres par l'interrupteur 21, ceux-ci gardant leur énergie oscillatrice jusqu'à l'apparition du signal D. Chaque voie de sélection comprend à sa sortie un amplificateur de mise en forme 29, 30 produisant chacun à sa sortie une onde rectangulaire en phase avec la basse fréquence filtrée. Les ondes rectangulaires sont transmises par les conducteurs 31, 32 aux entrées du circuit de mesure de phases faisant partie du dispositif logique à micro-processeur suivant la figure 4 à laquelle on se reportera ci-après.

Suivant cette figure 4, le dispositif logique comprend essentiellement un micro-processeur 50, un circuit d'entrées-sorties 51, un circuit mémoire 52, un bloc d'affichage 53, un décodeur d'adresse 54 et un clavier de commande 55.

Le micro-processeur fournit à une sortie un signal par exemple de 1 MHz obtenu à partir d'un quartz représenté schématiquement en 56. Cette sortie du micro-processeur est relié à un diviseur de fréquence 57 qui fournit par l'intermédiaire du conducteur 58 au circuit d'entrées-sorties 51 un signal logique par exemple de période égale à 6,144 msec. Le diviseur de fréquence 57 à une sortie intermédiaire à laquelle peut être prélevé le signal de référence transmis par le conducteur 9 au comparateur de fréquence 8 du canal de réception (figure 1). Le signal de référence a une période de 512 micro-secondes. En réponse au signal de 6,144 msec, le circuit d'entrée-sortie transmet au micro-processeur 50 à travers un bus de service 59 un signal d'interruption utilisé dans un programme moniteur pour engendrer par comptage les signaux de commande A, B, C et D formant signaux de multiplexage et pour établir en synchronisme des données numériques du bus 11 qui va au compteur-diviseur 10 du canal d'entrée et qui définit le taux de division de ce compteur et ainsi la fréquence de l'oscillateur local 4 et définit par conséquence la valeur de la fréquence radio en cours d'acquisition.

Le micro-processeur 50, le circuit d'entrées-sorties 51 et le circuit mémoire 52 sont interconnectés entre eux selon un schéma classique d'adresses et de données qu'on retrouve dans les manuels d'utilisation des circuits micro-processeurs de la famille 6800. Ce schéma est représenté sur la figure 4 par un bus d'adresses AO-15 et un bus de données DO-7. Le circuit mémoire 52 est une mémoire de 2 K.octets qui contient le programme de traitement dont il sera question ci-après. Le micro-processeur 50 qui est du type 6802 contient 128 octets de mémoire dite RAM pour le stockage des données intermédiaires établies en cours de programme. Le bus de donnée DO-7 fournit les informations au bloc d'affichage 53 et reçoit des informations du clavier de commande 55 par un bus 60. Le bloc d'affichage 53 et le clavier de commande 55 sont adressés par le micro-processeur 50 par l'intermédiaire du décodeur d'adresses 54 relié au bus d'adresse AO-15, comme il ressort de la figure. Le bus de service 59 permet également la transmission des commandes de l'initialisation de mise en route du circuit 51 et du micro-processeur 50, venant d'un circuit d'alimentation externe.

Comme il a été mentionné plus haut, le dispositif logique suivant la figure 4 permet l'établissement des déphasages des basses fréquences disponibles au conducteur 31, 32 aux sorties des voies de sélection 22, 23 du séparateur représenté sur la figure 2. Les mesures de phases de ces signaux s'effectuent par l'intermédiaire des bascules 63, 64 dont les sorties sont respectivement connectées à des entrées 65 et 66 du circuit d'entrées-sorties 51. Les bornes de remise à zéro de ces bascules sont reliées à une borne 67 du circuit 51 à laquelle est engendrée une impulsion de remise à zéro, en synchronisme avec le cycle de multiplexage.

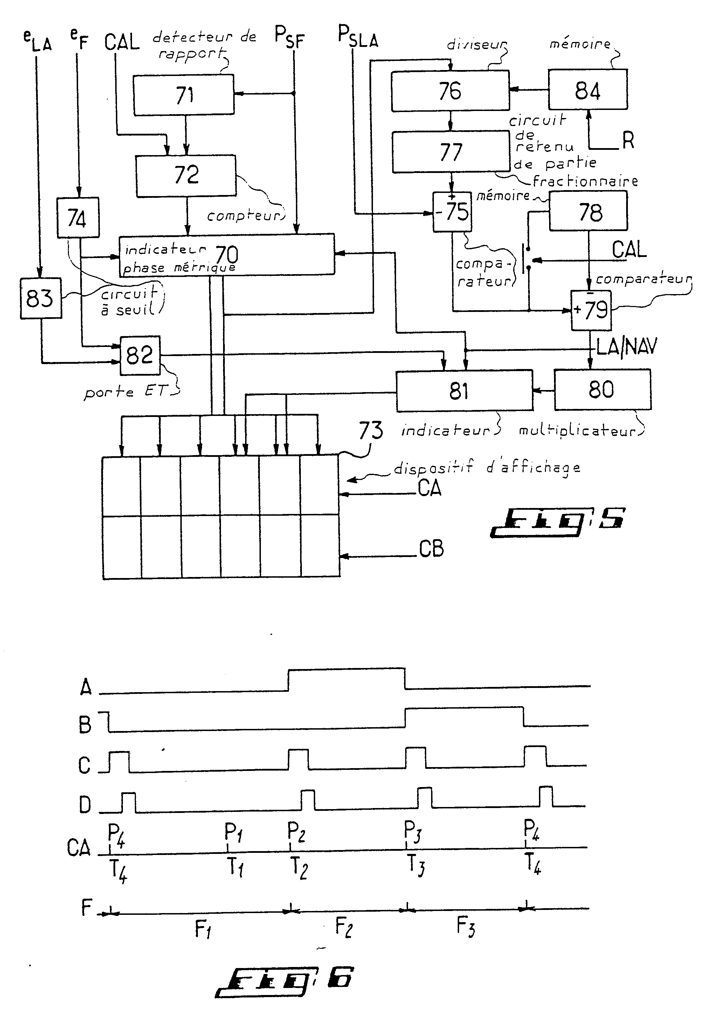

Avant de décrire le bloc d'affichage du dispositif récepteur représenté à la figure 5 et destiné à la visualisation des informations que lui transmet le dispositif logique, il convient tout d'abord d'expliquer les opérations essentielles effectuées par les différents dispositifs du récepteur et particulièrement du dispositif logique. Ces opérations seront expliquées notamment à l'aide de la figure 6.

La figure 6 donne un chronogramme des signaux de multiplexage A, B, C et D, des différentes périodes de multiplexage et des instants de prise de mesure. La ligne F illustre les périodes successives de commutation du canal d'entrée (figure 1) du dispositif récepteur selon l'invention sur les bandes de fréquences F1, F2 et F3, simultanément reçues par l'antenne. La bande de fréquence F1 contient les radio-fréquences fondamentales des deux couples des stations foyers fixes CA et CB. Les fréquences fondamentales de chaque couple sont écartées d'une basse fréquence. Les deux basses fréquences sont différentes. La bande F2 contient les deux fréquences de référence modulées par exemple sur une même porteuse. F3 illustre la bande contenant les fréquences de levée d'ambiguité. La ligne CA indique les instants de temps T1 à T4 où sont prélevées les mesures de phase relatives aux signaux du couple de stations foyers fixes CA et les valeurs P1, P2, P3 et P4 représentent les valeurs relevées à ces instants. Les instants de mesures relatives aux signaux provenant du couple de station foyer fixe CB ne sont pas illustrés, car ces signaux sont traités identiquement et quasi-simultanément avec les signaux du couple CA.

Pendant un cycle de commutation suivant la figure 6, le canal de réception (figure 1) est tout d'abord commuté sur la bande de fréquence F1, par accord approprié de l'oscillateur 4 et des amplificateurs 2 et 5, provoqué par des signaux de multiplexage A, B. Le mélangeur 3 effectue un battement des ondes de radio-fréquence des deux couples fondamentaux CA et CB. Le détecteur d'amplitude 6 produit ensuite les deux signaux de basse fréquence caractéristiques des deux couples. Ces signaux sont séparés dans l'étage séparateur (figure 2) et transformés en signaux rectangulaires et ensuite transmis aux bascules 63, 64 du dispositif logique de la figure 4. Après un temps de comptage de 20 périodes de signal d'interruption de 6,144 msec. envoyé par le circuit d'entrées-sorties 51 au micro-processeur 50 à travers le bus 59, donc après un temps d'environ 123 msec après l'établissement des fréquences de réception de mesure de la valeur de phase P1. A cette fin, le circuit d'entrées-sorties 51 engendre à sa borne 67 l'impulsion de remise à zéro des deux bascules 63 et 64. Simultanément, suivant son programme, le dispositif logique commence une période de comptage de temps rythmée par la fréquence d'horloge de 1 MHz produit par le micro-processeur 50. La première transition positive d'un signal de basse fréquence appliquée par le conducteur correspondant 31, 32 à la bascule 63 ou 64, qui suit la mise à zéro, replace à 1 la sortie de cette bascule. L'information est transmise à la borne 65 ou 66 du circuit 51 et envoyée au bus de données DO-7. Le comptage concernant cette bascule est arrêté et la durée enregistrée rapportée par calcul à la valeur de la période présumée du signal mesuré pour fournir une valeur de phase exprimée en centième de tour d'un phase-mètre rotatif, relatif à la phase de l'impulsion de remise à zéro. Pendant cette même période de commutation on effectue à l'instant T2 une deuxième opération de mesure identique à celle qui vient d'être décrite. Le temps qui sépare les deux instants T1 et T2 est avantageusement choisi égal à la moitié du temps précédent, c'est-à-dire l'intervalle T4-T1. Les valeurs de mesure P1 et P2, toutes deux faites sur F1 servent à établir la période exacte de chacun des deux signaux basse fréquence mesurés.

Ensuite on commute le canal de réception sur la bande de fréquence F2 contenant les fréquences de référence. Après traitement approprié de ces signaux, l'étage séparateur transmet deux signaux basse fréquence de référence aux bascules 63 et 64. Comme précédemment, après un temps d'environ 123 msec après la commutation, on mesure à l'instant de temps T3 la valeur de phase P3. Enfin le canal de réception est commuté sur les fréquences de levée d'ambiguité F3. A l'instant T4, après un même temps d'attente d'environ 123 msec, on mesure la valeur P4.

Il est connu que pour l'établissement des déphasages des couples de fréquences fondamentales et du déphasage des fréquences de levée d'ambiguité, il est nécessaire de mettre les valeurs correspondantes en rapport avec les valeurs de référence. Or, les opérations de mise en rapport ou de comparaison nécessitent une correction des valeurs mesurées pour éliminer leur décalage dans le temps provenant du multiplexage.

Cette correction est faite dans le micro-processeur suivant un programme prédéterminé. En établissant la différence des valeurs de phase P1–P2 et en moyennant les différences obtenues à chaque cycle suivant des équations correspondant au comportement d'un filtre de premier ordre de 20 secondes de constante de temps, le micro-processeur détermine l'écart de période Ep. A partir des valeurs de phase mesurées P1 à P4 et l'écart de période Ep, le micro-processeur obtient la phase fondamentale instantanée Pmf en effectuant la différence P2 − P3 et en corrigeant par deux fois la valeur de l'écart Ep. Il détermine la phase de levée d'ambiguité Pm. LA en effectuant P4−P2 corrigé de trois fois Ep.

$$Pmf = P2 - P3 + 2EP$$
$$Pm.LA = P4 - P2 + 3EP$$

Cette méthode de correction permet de définir les phases relatives exactes des trois types de signaux reçus à des instants distincts. Cette méthode est très avantageuse car elle ne nécessite aucune horloge synchrone ou rendue synchrone par asservissement aux signaux à mesurer.

Les valeurs de phase actualisées sont ensuite soumises dans le micro-processeur 50 à un traitement correspondant à celui d'un filtre des phases qui engendre pour chacune des données la phase moyenne filtrée Ps, la vitesse de phase V et la moyenne des écarts e établie en filtrant la valeur absolue des écarts entre phase filtrée et phase mesurée. Ce traitement analogue à celui d'un filtre des phases répond aux équations d'un filtre du deuxième ordre bien connu dans la technique:

$$V_{(t+1)} = V_{(t)} + K1 (Pm - Ps_{(t)})$$
$$Ps_{(t+1)} = Ps_{(t)} + K2 (Pm - Ps_{(t)}) + V_{(t)}$$
$$e_{(t+1)} = e_{(t)} + K3 ((Val. Abs. (Pm - Ps_{(t)})) - e_{(t)})$$

Ces équations assurent que les valeurs moyennes soient toujours suivies et actualisées. Dans ces équations, K1, K2 et K3 sont des constantes. K1 et K2 sont choisis pour obtenir le filtrage le plus serré tout en permettant de suivre les accélérations de phases entraînées par les modifications de route d'un mobile se déplaçant à une vitesse maximum 30 Km/h. La donnée filtrée e caractérise la dispersion des mesures successives Pm. Chaque écart est représentatif de la qualité de réception du signal filtré comparé à un seuil, e est utilisé dans la suite du programme pour valider les informations de position présentées sur le bloc d'affichage 53 (figure 4). Le dispositif logique produit des valeurs de phase moyenne filtrée $P_{sf}$ et $Ps.LA$ et des données filtrées $e_{LA}$ et $e_F$.

Le traitement effectué sur les deux phases filtrées relatives à un couple d'émetteur foyer $P_{sf}$ et $PS.LA$ est représenté par le schéma fonctionnel de la figure 5 à laquelle on se reportera à présent.

La phase fondamentale $P_{sf}$ est appliquée à un indicateur phasemétrique 70 sous forme de deux chiffres décimaux qui déterminent la partie fractionnaire de la phase estimée. Le signal $P_{sf}$ parvient en outre à un détecteur de rapport 71. Celui-ci est relié à un compteur incrémental à quatre décades 72 pour l'avancer d'une unité à chaque fois que $P_{sf}$ effectue un tour entier dans le sens croissant ou le reculer d'une unité lorsque le sens est décroissant. Le compteur 72 a une entrée de calage CAL. Le contenu du compteur 72 est appliqué à l'indicateur 70 sous forme de quatre chiffres décimaux qui déterminent la partie entière de la phase estimée $P_{sf}$. L'indicateur 70 agit sur un dispositif d'affichage 73 à deux séries de six chiffres, une série pour afficher la phase $P_{sf}$ relative au couple CA et l'autre série pour l'affichage de $P_{sf}$ relative à l'autre couple CB. Pour le calage de la phase estimée on positionne le compteur 72 par action sur deux touches avance/recul du clavier de commande 55 (figure 4).

Il est à noter que la phase estimée $P_{sf}$ appliquée à l'indicateur 70 est validée par la comparaison du signal $e_F$ fourni par le dispositif logique dans un circuit à seuil 74 à un seuil prédéterminé au dessus duquel $e_F$ déclenche un signal de défaut de la réception.

L'exploitation de la phase de levée d'ambiguité $Ps.LA$ se fait conformément au principe bien connu défini par le brevet français n° 1010811 de 1948. La fréquence de levée d'ambiguité et la fréquence fondamentale d'un couple émetteur de station foyer sont liées par un rapport n appelé rapport de levée d'ambiguité: fréquence de levée

$$d'ambiguité = (1 + \frac{1}{n} \times \text{fréquence fondamentale.}$$

Le rapport n peut être fractionnaire compris entre 3 et 9 et est défini par la cartographie relative à chaque couple de foyer. Le principe général indique que lorsque la phase fondamentale effectue n tour du fait du déplacement du récepteur, la phase différentielle, phase de la fréquence de levée d'ambiguité moins phase de la fréquence fondamentale, qu'on appelle ici phase de levée d'ambiguité $Ps.LA$ effectue exactement un tour. Le rapport n est spécifique d'un réseau.

Le bloc d'affichage comprend un comparateur-soustracteur 75. A une entrée de celui-ci est appliquée la valeur $Ps.LA$ fournie par le dispositif logique. Le comparateur reçoit à une autre entrée une valeur obtenue à partir de la phase fondamentale $P_{sf}$ prélevée à la sortie de l'indicateur 70, par division par n dans un diviseur 76. Le rapport n a été préalablement transmis à ce diviseur par un dispositif mémoire 84 dans lequel les rapports n sont inscrits en mémoire en face des données de fréquence de chacun des réseaux. Le quotient $P_{sf}/n$ formé par le diviseur 76 est égal à $Ps.LA$, mais peut être incorrect en raison du calage du compteur 72. Il est encore à noter qu'on a retenu en 77 la partie fractionnaire en se limitant à deux chiffres après la virgule. Le comparateur-soustracteur 75 permet, en comparant ces deux valeurs d'entrée, d'obtenir l'écart de calage brut qui existe entre les phases compte tenu de la valeur d'estime entrée dans le compteur 72. Cet écart brut peut être corrigé par un dispositif symbolisé sous forme d'une mémoire 78, à l'aide d'un autre comparateur-soustracteur 79. La sortie de ce dernier est reliée à un multiplicateur par le rapport n 80, pour obtenir une valeur de phase de la même sensibilité que celle présentée par l'affichage de phase du réseau fondamental. La donnée numérique, centrée autour de zéro, peut atteindre ± n/2 tours de phase. Le signal de sortie du multiplicateur 80 est transmis à un indicateur de la phase $Ps.LA$ 81. L'affichage est conditionné dans l'indicateur 81 par des valeurs éLA et é$_f$, à l'aide d'une porte ET 82 qui reçoit à une entrée la sortie du circuit à seuil 74 à laquelle est appliqué le signal é$_f$. A son autre entrée est relié un deuxième circuit à seuil 83 qui est relié à la borne d'entrée du signal éLA.

Le mode de réprésentation choisi permet une interprétation facile du résultat de traitement. Sur demande de l'opérateur, la donnée de l'indicateur 81 se substitue à l'affichage de la phase fondamentale estimée au lieux et places des digits concernés par l'information. Les chiffres non significatifs s'éteignent pour ne faire apparaître que les chiffres d'unités et le dixième de tour. Le calage idéal est indiqué par l'affichage de 0,0 en admettant une fluctuation de 0,3 tour sous l'effet des bruits de réception. Un décalage d'avance est signalé par l'affichage de 1,0±0,3, un décalage arrière par 9,0±0,3 ainsi de suite jusqu'à n/2 en écarts positif et 10−n/2 en écarts négatifs.

Le calage initial consiste à annuler l'écart par la mémoire de correction 78. L'opération s'effectue une fois pour toute en un repère géographique connu où les données entrées dans le compteur 72 sont jugées sûres. La commande s'effectue par le clavier d'entrées en appuyant simultanément sur une touche prévue pour le couple et sur une touche désignée par le sigle LA/NAV. L'écart brut de levée d'ambiguité est alors entré dans la mémoire 78 qui en fournissant sa donnée annule l'écart de sortie. La touche LA/NAV utilisée seule sert à commander l'affichage des données de levée d'ambiguïté sur les deux couples de foyer.

L'agencement décrit pour l'acquisition des phases et le traitement est conçu pour permettre au dispositif récepteur selon l'invention de se positionner dans toutes chaînes de radio localisation répondant aux caractéristiques définies précédemment. On entend par chaîne de façon générale un système à deux coordonnées hyperboliques couvrant une zone géographique déterminée et pouvant être équipée d'une fréquence de levée d'ambiguité. La mémoire de l'unité centrale contenue dans le dispositif logique à microprocesseur contient à cet effet la liste des fréquences d'émissions de chaque chaîne écrite dans un ordre convenable qui permet le traitement selon le processus décrit. Chaque chaîne numérotée de 0 à 7 peut être choisie par le clavier de commande 55 en appuyant sur la touche réseau symbolisée dans la figure 5 par R et en incrémentant le numéro de réseau qui apparaît alors sur le bloc d'affichage. Un programme clavier sollicité périodiquement par le programme moniteur gère les tâches d'initialisation et de commande de mode de représentation. Le bloc d'affichage du type à commande multiplexée est contrôlé par le programme d'interruption.

Bien que le dispositif récepteur qui vient d'être décrit soit notamment conçu pour l'usage maritime, il est à noter que l'invention n'est pas limitée à cette application.

### Revendications

1. Procédé de radio-localisation selon lequel la position d'un véhicule est déterminée par l'intersection d'une ligne hyperbolique d'iso-déphasage d'un premier couple d'ondes de radio-fréquence fondamentales avec la ligne hyperbolique d'iso-déphasage d'un second couple d'ondes de radio-fréquence fondamentales, lesquels couples sont transmis par des stations foyers fixes en combinaison avec au moins une onde de radio-fréquence de référence, et avantageusement également en combinaison avec un couple d'ondes de fréquence de levée d'ambiguïté associé à chaque couple d'ondes fondamentales, les ondes de chaque couple d'ondes de radio-fréquence fondamentales et de chaque couple associé de levée d'ambiguïté étant séparées par une basse fréquence différente de la basse fréquence séparant les ondes des deux autres couples associés d'ondes de radio-fréquence fondamentales et de levée d'ambiguïté, la où les ondes de radio-fréquence de référence étant modulées par les deux basses fréquences séparant les ondes des couples d'ondes fondamentales et de levée d'ambiguïté et servant de basses fréquences de référence, les ondes de radio-fréquence fondamentales, de référence et de levée d'ambiguïté étant émises simultanément et appartenant respectivement à des bandes de fréquence différentes, ce procédé comprenant les opérations consistant à développer dans un poste récepteur à partir de chaque couple d'ondes fondamentales la basse fréquence associée servant de basse fréquence de radio-localisation, à développer à partir de la ou des ondes de la radio-fréquence de référence les basses fréquences de référence précitées, à développer, le cas échéant, à partir des ondes de fréquences de levée d'ambiguïté les basses fréquences correspondantes et à établir la position dudit véhicule en déterminant la phase relative entre la basse fréquence de radio-localisation de chaque couple d'ondes fondamentales et la basse fréquence de référence associée, et, le cas échéant, la phase relative entre chaque basse fréquence dérivée des ondes de fréquence de levée d'ambiguïté et la basse fréquence de référence associée, le procédé étant caractérisé en ce qu'il comprend les opérations consistant à recevoir par commutation convenable de l'accord d'un seul canal de réception formé dans le poste récepteur pendant chacun des cycles d'un nombre de cycles successifs, au cours de périodes de temps prédéterminées successives de chaque cycle, respectivement lesdites ondes fondamentales, les ondes de référence et, le cas échéant, les ondes de levée d'ambiguïté, à établir lesdites phases relatives à partir des phases de basse fréquence correspondantes reçues séquentiellement, lesquelles phases de basse fréquence sont mesurées l'une après l'autre par rapport à un instant de référence fixé par le poste récepteur, et à corriger les valeurs de phase relative par calcul en utilisant une valeur de correction obtenue par établissement de la moyenne des écarts de phase mesurés sur une même basse fréquence de radio-localisation entre deux instants prédéterminés délimitant un laps de temps connu pendant chaque cycle.

2. Procédé selon la revendication 1, caractérisé en ce que l'on mesure la phase (P1 à P4) de chaque basse fréquence par rapport à un signal local recurrent produit par un oscillateur local à des intervalles de temps prédéterminés, mesure à chacun des cycles précités pendant la période de réception (F1) des ondes fondamentales la phase (P1, P2) de la basse fréquence de radio-localisation auxdits deux instants de temps (T1, T2) séparés par le laps de temps connu, établit la différence de phase des deux valeurs de phase mesurées (P1, P2) et une valeur moyenne (Ep) de ladite différence.

3. Procédé selon la revendication 2, caractérisé en ce qu'il comprend les opérations de développer à partir des valeurs de phases relatives corrigées des valeurs de phase moyenne selon des équations d'un filtre de second ordre, selon lesquelles la valeur de phase moyenne d'un cycle présent est développé par formation de la somme de la valeur relative moyenne du cycle précédent, d'une valeur relative proportionnelle à la différence de phase entre la valeur de phase mesurée corrigée et la valeur de phase relative moyenne du cycle précédent et de la vitesse de phase qui a été établie pour le cycle précédent, les valeurs de phase relatives moyennes étant utilisées pour déterminer la localisation dudit véhicule.

4. Dispositif récepteur pour la mise en œuvre du procédé selon l'une des revendications précédentes, caractérisé en ce qu'il comprend un seul canal de réception (I) dont la fréquence d'accord est commutable, pendant des périodes de temps successives, sur les différentes bandes de fréquence dans lesquelles se trouvent respectivement les ondes de radio-fréquence fondamentales, les ondes de radio-fréquence de référence et les ondes de levée d'ambiguïté, et un dispositif logique à micro-processeur (III) chargé d'assurer (a) la commutation du canal de réception, (b) l'établissement des phases relatives ainsi que de la moyenne des écarts de phase formant la valeur de correction telle que définie dans la revendication 1, et (c) la correction desdites valeurs de phase relatives par ladite valeur de correction.

5. Dispositif récepteur selon la revendication 4, caractérisé en ce que le canal de réception (I) est un canal à démodulation d'amplitude et est adapté pour produire deux basses fréquences à partir de deux couples d'ondes fondamentales, un dispositif séparateur (II) des basses fréquences étant monté en aval dudit canal de réception (I), et en ce que le dispositif logique (III) comprend un oscillateur générateur de signaux d'horloge, des moyens compteurs pour mesurer les phases des signaux basse fréquence par rapport à la phase des signaux d'horloge et une unité centrale de calcul pour produire les phases relatives représentatives des lieux de position hyperbolique par correction des valeurs mesurées décalées dans le temps.

6. Dispositif récepteur selon l'une des revendications 4 ou 5, caractérisé en ce qu'il comprend un indicateur numérique (70, 73, 81), à deux nombres de six chiffres pour représenter alternativement, d'une part les valeurs des lieux de position hyperbolique des deux couples fondamentaux d'une chaîne de positionnement, et, d'autre part, pour chacun des couples, l'écart de coincidence de la phase fondamentale et de la phase de levée d'ambiguïté par deux chiffres d'unité et de dixième de tour, l'affichage de l'écart se substituant momentanément à l'affichage de la phase fondamentale.

7. Dispositif récepteur selon l'une des revendications 4 à 6, caractérisé en ce que le canal de réception (I) comprend un montage en série d'un amplificateur d'entrée (2), d'un mélangeur (3), d'un amplificateur de fréquence intermédiaire (5) et d'un détecteur d'amplitude (6) et un oscillateur local (4) associé au mélangeur (3), l'amplificateur d'entrée (2) et l'oscillateur local (4) étant accordables sous la commande du dispositif logique à micro-processeur (II) par l'intermédiaire d'un bus de données (11) à neuf conducteurs définissant à chaque instant de manière numérique binaire la fréquence centrale en cours d'amplification, et en ce qu'il comprend deux dispositifs multiplexeurs (12, 14) pourvus chacun d'une série de condensateurs, dont certains sont reliés sous l'effet simultané de deux signaux logiques (A et B) provenant du dispositif logique à micro-processeurs (III) respectivement auxdites amplificateurs et à l'oscillateur local.

8. Dispositif récepteur selon la revendication 7, caractérisé en ce que le canal d'entrée (I) est adapté pour acquérir cycliquement en un temps court inférieur à 0,6 seconde un maximum de quatre bandes de fréquence situées dans la gamme maritime comprise entre 1,6 et 2,6 MHz en réponse audit bus de données (11).

9. Dispositif selon l'une des revendications 5 à 8, caractérisé en ce que l'étage séparateur (II) comprend dans chaque voie de séparation (22, 23) plusieurs cellules formant filtre actif (24, 25), un interrupteur (21) situé en amont des deux voies (22, 23) et susceptible d'être ouvert sous l'effet d'un signal logique C transmis par le dispositif logique (III) à des instants prédéterminés du cycle de multiplexage des fréquences radio pour éliminer le transfert des impulsions de transition engendré par la commutation des fréquences radio et maintenir les signaux à leur valeur finale pendant une durée qui permet les mesures de phases, et des interrupteurs d'initialisation (28) destinés à placer les cellules au départ de chaque période de commutation dans l'état qui correspond à l'application de signaux d'amplitude nulle, lorsqu'ils sont fermés sous l'effet d'un signal logique (D) provenant du dispositif logique (III).

10. Dispositif récepteur selon l'une des revendications 4 à 9, caractérisé en ce que, pour les mesures des déphasages des signaux basse fréquence effectuées sous le contrôle d'un programme micro-processeur, le dispositif logique (III) comprend à son entrée deux bascules (63, 64) destinées à recevoir les signaux basse fréquence et agencées pour être remises à zéro à un instant de temps prédéterminé et pour être mis à l'état 1 à la réception d'un signal basse fréquence, et des moyens compteurs du temps entre la mise à zéro et la mise à l'état 1 et des moyens de calcul adaptés pour rapporter par calcul de proportionnalité le temps mesuré à la période présumée du signal afin d'obtenir une valeur de déphasage instantanée exprimée en fraction de tours.

11. Dispositif récepteur selon une des revendications 4 à 10, caractérisé en ce qu'il comprend un dispositif de traitement et d'affichage (53), qui comprend pour le traitement de chaque phase de levée d'ambiguïté des moyens diviseurs (76) destinés à effectuer par programme la division de la phase fondamentale estimée par un rapport de levée d'ambiguïté n reconnu dans le programme par le réseau dans lequel se trouve le récepteur, des moyens (77) destinés à retenir la partie fractionnaire du résultat de la division, des moyens comparateurs (75) destinés à soustraire de ce résultat la phase de levée d'ambiguïté, des moyens correcteurs (79, 78) pour corriger éventuellement cet écart de coincidence brute, des moyens (80) pour multiplier le résultat par ledit rapport n pour obtenir une donnée de même sensibilité que celle de la phase fondamentale, centrée autour d'une valeur nulle et apte à représenter n/2 tours pour les écarts positifs et 10 − n/2 tours pour les écarts négatifs.

## Claims

1. Method of radio-locating according to which the position of a vehicle is determined by the intersection of an hyperbolic isophase-shift line of a first pair of fundamental waves of radio-frequency with the hyperbolic isophase-shift line of a second pair of fundamental waves of radio-frequency, which pairs are transmitted by stationary focus stations in combination with at least one wave of reference radio-frequency and advantageously also in combination with a pair of waves of ambiguity-removing frequency associated with each pair of fundamental waves, the waves of each pair of fundamental waves of radio-frequency and of each associated ambiguity-removing pair being separated by a low frequency different from the low frequency separating the waves of the two other associated pairs of fundamental radio-frequency and ambiguity-removing waves, the reference radio-frequency wave(s) being modulated by both low frequencies separating the waves of the pairs of fundamental and ambiguity-removing waves and serving as low reference frequencies, the fundamental radio-frequency, reference and ambiguity-removing waves being emitted simultaneously and belonging to different frequency bands, respectively, this method comprising the steps consisting in developping from each pair of fundamental waves in a receiver set the associated low frequency serving as a low radio-localizing frequency, in developping from the reference radio-frequency wave(s) the aforesaid low reference frequencies, in developing, as the case may be, from the waves of ambiguity-removing frequencies the corresponding low frequencies and in establishing the position of the said vehicle by determining the relative phase between the low radio-locating frequency of each pair of fundamental waves and the associated low reference frequency and, as the case may be, the relative phase between each low frequency derived from the ambiguity-removing frequency waves and the associated low reference frequency, the method being characterized in that it comprises the steps consisting in receiving through proper switching of the tuning of a single receiving channel formed in the receiver set during each one of the cycles of a number of successive cycles in the course of successive predetermined time periods of each cycle, the said fundamental waves, the reference waves and as the case may be, the ambiguity-removing waves, respectively, in establishing the said relative phases from the sequentially received corresponding low frequency phases, which low frequency phases are measured one after the other with respect to a reference moment set by the receiver set and in correcting the relative phase values through computation by using a correction value obtained by the establishing of the average of the measured phase deviations on a same low radio-locating frequency between two predetermined moments defining a known lapse of time during each cycle.

2. Method according to claim 1, characterized in that one measures the phase (P1 to P4) of each low frequency with respect to a local recurrent signal produced by a local oscillator at predetermined time intervals, one measures at each one of the aforesaid cycles during the period (F1) of receiving of the fundamental waves the phase (P1, P2) of the local radio-locating frequency at said both time moments (T1, T2) separated by the known lapse of time, one establishes the phase difference of both measured phase values (P1, P2) and a mean value ($E_p$) of the said difference.

3. Method according to claim 2, characterized in that it comprises the steps of developping from the corrected values of relative phases mean phase values according to the equations of a filter of the second order, according to which the mean phase value of one cycle present is developed by forming of the sum of the mean relative value of the preceding cycle, of a relative value proportional to the phase difference between the corrected measured phase value and the mean relative phase of the preceding cycle and of the phase speed which has been established for the preceding cycle, the mean relative phase values being used to determine the position of the said vehicle.

4. Receiver device for carrying out the method according to one of the foregoing claims, characterized in that it comprises one single receiving channel (1) the tuning frequency of which is switchable during successive periods of time to the different frequency bands in which are the fundamental waves of radio-frequency, the reference radio-frequency waves and the ambiguity-removing waves and a logic microprocessor device (III) adapted to provide (a) the switching of the receiving channel, (b) the establishing of the relative phases as well as of the average of the phase deviations forming the correction value such as defined in claim 1, and (c) the correction of the said relative phase values by the said correction value.

5. Receiver device according to claim 4, characterized in that the receiving channel (I) is an amplitude demodulation channel and is adapted to produce two low frequencies from both pairs of fundamental waves, a low frequencies separator device (II) being mounted downstream of the said receiving channel (I) and in that the logic device (III) comprises a clock signal generating oscillator, counting means for measuring the phases of the low frequency signals with respect to the phase of the clock signals and a central computing unit for producing the relative phases representative of the hyperbolic position locii through correction of the measured time-shifted values.

6. Receiver device according to one of claims 4 or 5, characterized in that it comprises a digital indicator (70, 73, 81) with two six-figure numbers for alternately representing on the one hand, the hyperbolic position locii of both fundamental pairs of a positioning line and, on the other hand, for each one of the pairs, the coincidence deviation of the fundamental phase and of the ambiguity-removing phase by two figures of unit and of a tenth of revolution, the display of the deviation being momentarily substituted for the display of the fundamental phase.

7. Receiver device according to one of claims 4 to 6, characterized in that the receiving channel (1) comprises a mounting in series of an input amplifier (2), of a mixer (3), of an intermediate frequency amplifier (5) and of an amplitude detector (6) and a local oscillator (4) associated with the mixer (3), the input amplifier (2) and the local oscillator (4) being tunable under the control of the logic microprocessor device (II) through the medium of a data bus (11) with nine leads defining at every moment in a binary digital way the centre frequency being amplified and in that it comprises two multiplexer devices (12, 14) provided each one with a series of capacitors some of which are connected under the simultaneous effect of both logic signals (A and B) issued from the logic microprocessors device (III) to the said amplifiers and to the local oscillator, respectively.

8. Receiver device according to claim 7, characterized in that the input channel (I) is adapted to cyclicly acquire within a short time lower than 0.6 second a maximum of four frequency bands located in the maritime range comprised between 1.6 and 2.6 MHz in response to the said data bus (11).

9. Receiver device according to one of the claims 5 to 8, characterized in that the separator stage (2) comprises in each separating line (22, 23) several cells forming an active filter (24, 25), a switch (21) located upstream of both lines (22, 23) and likely to e opened under the effect of a logic signal C transmitted by the logic device (III) at predetermined moments of the cycle for the multiplexing of the radio-frequencies to remove the transfer of the transition pulses generated by the switching of the radio-frequencies and to maintain the signals at their final value for a duration which allows the measures of phases and initiating switches (28) adapted to put the cells at the start of each switching period in the state which corresponds to the applying of zero amplitude signals when they are closed under the effect of a logic signal (D) issuing from the logic device (III).

10. Receiver device according to one of the claims 4 to 9, characterized in that for the measures of the phase-shifts of the low frequency signals effected under the control of a microprocessor programme, the logic device (III) comprises at its input two flip-flop circuits (63, 64) adapted to receive the low frequency signals and arranged for being reset at a predetermined time moment and for being put in the state 1 on receiving of a low frequency signal and means for counting the time between the resetting and the putting in the state 1 and computation means adapted to make through a proportionality computation the ratio of the measured time to the presumed period of the signal in order to obtain an instantaneous phase-shift value expressed as a fraction of revolution.

11. Receiver device according to one of the claims 4 to 10, characterized in that it comprises a processing and displaying device (53) which comprises for the processing of each ambiguity-removing phase dividing means (76) adapted to effect through a programme the division of the estimated fundamental phase by an ambiguity-removing ratio n identified in the programme by the network in which is the receiver, means (77) adapted to retain the fractional portion of the result of the division, comparator means (75) adapted to substract from this result the ambiguity-removing phase, correcting means (79, 78) to possibly correct this gross coincidence deviation, means (80) to multiply the result with the said ratio n for obtaining a data of the same sensitivity than that of the fundamental phase, centered about a zero value and capable of representing n/2 revolutions for the positive deviations and $10-n/2$ revolutions for the negative deviations.

**Patentansprüche**

1. Funkortungsverfahren gemäss welchem die Lage eines Fahrzeugs durch den Schnittpunkt einer hyperbolischen Isophasenverschiebungslinie eines ersten Paares von Funkfrequenzgrundwellen und der hyperbolischen Isophasenverschiebungslinie eines zweiten Paares von Funkfrequenzgrundwellen bestimmt wird, welche Paare durch feststehende Fokusstationen in Verbindung mit wenigstens einer Funkfrequenzbezugswelle und in vorteilhafter Weise auch in Verbindung mit einem jedem Paar von Grundwellen zugeordneten Wellenpaar mit die Mehrdeutigkeit aufhebender Frequenz übertragen werden, wobei die Wellen jedes Paares von Funkfrequenzgrundwellen und von jedem zugeordneten die Mehrdeutigkeit aufhebenden Paar durch eine Niederfrequenz getrennt sind, die sich von der die Wellen der beiden anderen zugeordneten Paaren von Funkfrequenzgrund- und die Mehrdeutigkeit aufhebenden Wellen trennenden Niederfrequenz unterscheidet, wobei die Funkfrequenzbezugswelle(n) durch die beiden die Wellen der Paaren von Grund- und die Mehrdeutigkeit aufhebenden Wellen trennenden und als Bezugsniederfrequenzen dienenden Niederfrequenzen moduliert werden, wobei die Funkfrequenzgrund-, Bezugs- und die Mehrdeutigkeit aufhebenden Wellen gleichzeitig ausgesandt werden und jeweils zu unterschiedlichen Frequenzbändern gehören, wobei dieses Verfahren die Schritte umfasst, die darin bestehen, aus jedem Paar von Grundwellen in einem Empfangsgerät die zugeordnete als Funkortungsniederfrequenz dienende Niederfrequenz zu entwickeln, die vorgenannten Bezugsniederfrequenzen aus der bzw. den Funkfrequenzbezugswellen zu entwickeln, gegebenenfalls aus den Wellen mit den die Mehrdeutigkeit aufhebenden Frequenzen, die entsprechenden Niederfrequenzen zu entwickeln und die Stellung des besagten Fahrzeugs zu ermitteln durch Bestimmung der Relativphase zwischen der Funkortungsniederfrequenz jedes Paares von Grundwellen und der zugeordneten Bezugsniederfrequenz und gegebenenfalls der Relativphase zwischen jeder von den Wellen mit die Mehrdeutigkeit aufhebenden Frequenz abgeleiteten Niederfrequenz und der zugeordneten Bezugsniederfrequenz, wobei das Verfahren dadurch gekennzeichnet ist, dass es die Schritte umfasst, die darin bestehen, jeweils die besagten Grundwellen, die Bezugswellen und gegebenenfalls die die Mehrdeutigkeit aufhebenden Wellen durch geeignetes Schalten der Abstimmung eines einzigen in dem Empfangsgerät gebildeten Empfangskanal während jedem der Zyklen einer Anzahl von aufeinanderfolgenden Zyklen während aufeinanderfolgenden vorbestimmten Zeiträumen jedes Zyklus zu empfangen, die besagten Relativphasen aus den entsprechenden folgegebunden empfangenen Niederfrequenzphasen zu ermitteln, wobei diese Niederfrequenzphasen nacheinander in bezug auf einen durch das Empfangsgerät festgesetzten Bezugszeitpunkt gemessen werden und die Relativphasenwerte durch Berechnen zu berichtigen unter Verwendung des durch die Ermittlung des Mittels der Phasenhube erzielten Korrekturwertes, welche an einer selben Funkortungsniederfrequenz zwischen zwei, eine während jedem Zyklus bekannte Zeitspanne begrenzenden vorbestimmten Zeitpunkten gemessen werden.

2. Verfahren nach Anspruch 1, dadurch gekennzeichnet, dass man die Phase (P1 bis P4) jeder Niederfrequenz in bezug auf ein durch einen örtlichen Schwingungserzeuger in vorbestimmten Zeitabschnitten erzeugtes örtliches wiederkehrendes Signal misst, man bei jedem der vorgenannten Zyklen während dem Empfangszeitraum (F1) der Grundwellen die Phase (P1, P2) der Funkortungsniederfrequenz zu den besagten beiden durch die bekannte Zeitspanne getrennten Zeitpunkten (T1, T2) misst, man den Phasenunterschied der beiden gemessenen Phasenwerte (P1, P2) und einen Durchschnittswert (Ep) des besagten Unterschiedes ermittelt.

3. Verfahren nach Anspruch 2, dadurch gekennzeichnet, dass es die Schritte umfasst, die darin bestehen, aus den berichtigten Relativphasenwerten Mittelphasenwerte gemäss den Gleichungen eines Filters der zweiten Ordnung zu entwikkeln, gemäss welchen der Durchschnittsphasenwert eines vorliegenden Zyklus durch die Bildung der Summe des Mittelrelativwertes des vorangehenden Zyklus eines mit dem Phasenunterschied zwischen dem berichtigten gemessenen Phasenwert und dem Durchschnittsrelativphasenwert des vorangehenden Zyklus proportionalen Relativwertes und der Phasengeschwindigkeit, die für den vorangehenden Zyklus ermittelt worden ist, entwickelt wird, wobei die Durchschnittsrelativphasenwerte zur Bestimmung der Ortung des besagten Fahrzeugs verwendet werden.

4. Empfangsvorrichtung zur Durchführung des Verfahrens nach einem der vorangehenden Ansprüche, dadurch gekennzeichnet, dass sie einen einzigen Empfangskanal (I) deren Abstimmungsfrequenz während aufeinanderfolgenden Zeiträumen auf die verschiedenen Frequenzbänder in welchen sich jeweils die Funkfrequenzgrundwellen, die Funkfrequenzbezugswellen und die die Mehrdeutigkeit aufhebenden Wellen befinden, umschaltbar ist, und eine Logikvorrichtung mit Mikroprozessor (III) umfasst, welche bestimmt ist, (a) die Umschaltung des Empfangskanals, (b) die Ermittlung der Relativphasen sowie des dem wie in Anspruch 1 festgelegten Korrekturwert bildenden Mittels der Phasenhube und (c) die Berichtigung der besagten Relativphasenwerte durch den besagten Korrekturwert zu gewährleisten.

5. Empfangsvorrichtung nach Anspruch 4, dadurch gekennzeichnet, dass der Empfangskanal (I) ein Amplitudendemodulationskanal ist und geeignet ist, zwei Niederfrequenzen aus den beiden Paaren von Grundwellen zu erzeugen, wobei eine Vorrichtung (II) zur Trennung der Niederfrequenzen stromabwärts des besagten Empfangskanals (I) angeordnet ist und dass die Logikvorrichtung (III) einen Taktimpulse erzeugenden Oszillator, Zählermittel zum Messen der Phasen der Niederfrequenzsignale in bezug auf die Phase der Taktimpulse und eine Zentralrecheneinheit zur Erzeugung der die hyperbolischen Lagenorte darstellenden Relativphasen durch Berichtigung der zeitlich versetzten gemessenen Werte umfasst.

6. Empfangsvorrichtung nach einem der Ansprüche 4 oder 5, dadurch gekennzeichnet, dass sie einen numerischen Anzeiger (70, 73, 81) mit zwei Zahlen von sechs Ziffern umfasst, zur wechselweisen Darstellung einerseits der Werte der hyperbolischen Lagenorte der beiden Grundpaare einer Positionierungskette und andererseits für jedes der Paare, des Übereinstimmungshubes der Grundphase und der die Mehrdeutigkeit aufhebenden Phase durch zwei Ziffern der Einheit und des Zehntels einer Umdrehung, wobei die Anzeige des Hubes die Anzeige der Grundphase momentan ersetzt.

7. Empfangsvorrichtung gemäss einem der Ansprüche 4 bis 6 dadurch gekennzeichnet, dass der Empfangskanal (I) eine Reihenschaltung eines Eingangsverstärkers (2), eines Mischers (3), eines

**0 059 138**

Zwischenfrequenzverstärkers (5) und eines Amplitudendetektors (6) und eines dem Mischer (3) zugeordneten örtlichen Oszillators (4) umfasst, wobei der Eingangsverstärker (2) und der örtliche Oszillator (4) unter der Steuerung der Logikvorrichtung mit Mikroprozessor (II) über einen in numerischer binärischer Weise zu jedem Zeitpunkt, die eine Verstärkung erfahrende Mittenfrequenz bestimmenden Datenübertragungsbus (11) mit neun Leitern abstimmbar sind und dass sie zwei Multiplexervorrichtungen (12, 14) umfasst, die jeweils mit einer Reihe von Kondensatoren versehen sind, von denen gewisse unter der gleichzeitigen Wirkung der beiden aus der Logikvorrichtung mit Mikroprozessoren (III) kommenden Logiksignalen (A und B) jeweils mit den besagten Verstärkern und mit dem örtlichen Oszillator verbunden sind.

8. Empfangsvorrichtung gemäss Anspruch 7, dadurch gekennzeichnet, dass der Eingangskanal (I) angepasst ist, um in einer kurzen Zeit von weniger als 0,6 Sekunde ein Maximum von vier in dem Marinebereich zwischen 1,6 und 2,6 MHz gelegenen Frequenzbändern in Erwiderung auf den besagten Datenübertragungsbus (11) zyklisch zu gewinnen.

9. Empfangsvorrichtung nach einem der Ansprüche 5 bis 8, dadurch gekennzeichnet, dass die Trennstufe (II) in jedem Trennweg (22, 23) mehrere einen aktiven Filter bildende Zellen (24, 25), einen oberstromig der beiden Wege (22, 23) gelegenen Schalter (21), der sich unter der Wirkung eines von der Logikvorrichtung (III) übertragenen Logiksignals C zu vorbestimmten Zeitpunkten des Zyklus zum Multiplexieren der Funkfrequenzen öffnen kann, zur Beseitigung des durch die Umschaltung der Funkfrequenzen erzeugten Überganges der Durchgangsimpulse und zur Aufrechterhaltung der Signale auf ihren endgültigen Wert während einer Dauer, die die Messungen der Phasen gestattet, und Initialisierungsschalter (28) die bestimmt sind, die Zellen am Anfang jeder Umschaltungsperiode in denjenigen Zustand zu versetzen, der der Anwendung von Nullamplitudensignalen entspricht, wenn sie unter der Wirkung eines von der Logikvorrichtung (III) herrührendes Logiksignals (D) geschlossen sind, umfasst.

10. Empfangsvorrichtung nach einem der Ansprüche 4 bis 9, dadurch gekennzeichnet, dass, für die unter durch Steuerung eines Mikroprozessorprogramms durchgeführten Messungen der Phasenverschiebungen der Niederfrequenzsignale, die Logikvorrichtung (III) an ihrem Eingang zwei Kippschaltungen (63, 64) umfasst, die bestimmt sind, die Niederfrequenzsignale zu empfangen und eingerichtet sind, um zu einem vorbestimmten Zeitpunkt auf Null zurückgestellt zu werden, und um in den Zustand 1 bei Empfang eines Niederfrequenzsignals gebracht zu werden, und Mittel zur Zählung der Zeit zwischen der Zurückstellung auf Null und der Bringung in den Zustand 1 und Rechnungsmittel die angepasst sind, um durch Proportionalitätsrechnung die gemessene Zeit auf die vermutliche Periode des Signals zu beziehen, um einen als ein Umdrehungsbruchteil ausgedrückten ausgenblicklichen Phasenverschiebungswert zu erhalten, umfasst.

11. Empfangsvorrichtung gemäss einem der Ansprüche 4 bis 10, dadurch gekennzeichnet, dass sie eine Verarbeitungs- und Anzeigevorrichtung (53) umfasst, die, für die Verarbeitung jeder die Mehrdeutigkeit aufhebenden Phase, Teilermittel (76) zur programmässigen Durchführung der geschätzten Grundphase durch ein in dem Programm von dem Netz in welchem sich der Empfänger befindet, erkannten die Mehrdeutigkeit aufhebenden Verhältnis n, Mittel (77) zur Zurückhaltung des Bruchteiles des Ergebnisses der Teilung, Vergleichsmittel (75) zum Abziehen der die Mehrdeutigkeit aufhebenden Phase von diesem Ergebnis, Korrekturmittel (79, 78) zur etwaigen Berichtigung dieser Übereinstimmungsbruttoabweichung, Mittel (80) zum Multiplizieren des Ergebnisses mit dem besagten Verhältnis n zur Erzielung einer Angabe derselben Empfindlichkeit wie diejenige der Grundphase und die um den Nullwert zentriert ist und fähig ist, n/2 Umdrehungen für die positiven Abweichungen und $10-n/2$ Umdrehungen für die negativen Abweichungen darzustellen, umfasst.

**Fig. 1**

I

multiplexeur

12

A
B

1

2

mélangeur

amplificateur
d'entreé

amplificateur
accordable

detecteur
d'amplitude

13

7

3

5

6

14

oscillateur

compteur-diviseur

11

4

10

multiplexeur

A B

comparateur
de frequences

9

8

**Fig. 2**

adaptateur

21

22

filtre

limiteur
d'amplitude

filtre

29

31

II

20

24

24

26

24

D

C₂

23

25

25

27

25

30

32

filtre

limiteur
d'amplitude

filtre

amplificateur
de mise en forme

**Fig. 3**

C₂

C₁

R₂

R₁

28

D

diviseur de frequence

III

9

58 57

diviseur de frequence

oscillateur à quartz

51

11

mémoire ROM 52

50

56

A
B
C
D

circuit entreé-sortie

AO-15

micropro-cesseur

bascule

65

31

67

59

DO-7

64

66

54

décodeur d'adresse

60

32

bascule

53

55

Fig 9

bloc d'affichage

clavier de commende

0 059 138

*Fig 5*

*Fig 6*